# EUROPEAN PATENT APPLICATION

(11) **EP 4 755 953 A1**
(43) Date of publication of application: **10.06.2026**
(21) Application number: 24849161.5
(22) Date of filing: 30.07.2024
(51) Int. Cl.: C08J 5/18, C08F 210/00, C08F 212/08, C08F 212/36, C08L 25/08, H01B 3/44, H05K 1/03

(54) **UNCURED SHEET AND CURED BODY OF SAME**

(30) Priority: 02.08.2023 JP 2023126446
(71) Applicant: Denka Company Limited, Tokyo 103-8338 (JP)
(72) Inventor: ARAI, Toru, Tokyo 103-8338 (JP); KANTO, Ryosuke, Tokyo 103-8338 (JP); ISHIGAKI, Yuhei, Tokyo 103-8338 (JP)
(74) Representative: Müller-Boré & Partner Patentanwälte PartG mbB
(86) International application number: PCT/JP2024/027116
(87) International publication number: WO 2025/028516

(57) **Abstract**

An object of the present disclosure is to reduce the tackiness in an uncured sheet, and the like. An uncured sheet of the present disclosure is composed of a composition containing an olefin / aromatic vinyl compound / aromatic polyene copolymer that satisfies the following condition (2a), and having a tack force at 25°C of 2 N or less by a probe tack test.
(2a) The content of aromatic vinyl compound monomer units is in the range of 60% by mass or more and 80% by mass or less, and the total of aromatic vinyl compound monomer units, aromatic polyene monomer units, and olefin monomer units is 100% by mass.

## Description

### Technical Field

The present invention relates to uncured sheets, and insulating materials which are cured products thereof.

### Background Art

With the transition of communication frequencies to the gigahertz band and higher frequency bands, there is an increasing demand for multilayer substrates, transmission lines, antennas, and the like made of CCLs and FCCLs including insulating materials with low dielectric characteristics. Fluororesins such as perfluoroethylene exhibit excellent characteristics including low dielectric constant, low dielectric loss, and heat resistance, but they have difficulties in forming processability and film formability, and also present challenges in adhesion to copper foil for wiring, making their application to multilayer substrates and the like difficult. On the other hand, substrates and insulating materials using post-curing resins such as epoxy resins, unsaturated polyester resins, polyimide resins, and phenolic resins have been widely used due to their heat resistance and ease of handling, but their dielectric constant and dielectric loss are relatively high, and improvements are desired as insulating materials for high frequencies (Patent Literature 1).

Accordingly, attention has been focused on hydrocarbon resins that essentially have low dielectric characteristics. In order to make hydrocarbon resins, which are originally thermoplastic resins, into curable resins, it is necessary to introduce functional groups. However, since functional groups that generally undergo crosslinking reactions by radicals or heat have polarity, when such functional groups are introduced into hydrocarbon resins, the dielectric characteristics deteriorate. When attempting to introduce functional groups composed only of hydrocarbons, such as aromatic vinyl groups, it is often the case that intermolecular reactions between expensive hydrocarbon monomers are utilized (Patent Literature 2), which is often uneconomical. Patent Literature 3 discloses cured products composed of an ethylene / olefin (aromatic vinyl compound) / aromatic polyene copolymer and a non-polar vinyl compound copolymer, which are obtained from a specific coordination polymerization catalyst and have specific compositional features and formulation. In the case of this technique, since only one of the two vinyl groups of the aromatic polyene (divinylbenzene) is selectively copolymerized and the remaining vinyl group is preserved, it is possible to readily obtain a crosslinkable hydrocarbon-based copolymer macromonomer having an aromatic vinyl functional group. Similar olefin / aromatic vinyl compound / aromatic polyene copolymers, as well as cured products obtained from compositions with sub-raw materials and the like, have characteristics of low dielectric constant and low dielectric loss tangent (Patent Literatures 4, 5, and 6).

### Citation List

### Patent Literature

Patent Literature 1: Japanese Patent Laid-Open No. 06-192392
Patent Literature 2: Japanese Patent Laid-Open No. 2004-087639
Patent Literature 3: Japanese Patent Laid-Open No. 2007-217706
Patent Literature 4: International Publication No. WO 2021/112087
Patent Literature 5: International Publication No. WO 2021/112088
Patent Literature 6: International Publication No. WO 2022/014599

### Summary of Invention

### Technical Problem

Here, in the case where low dielectric resin materials for high frequency insulation involved in the prior art are provided as sheets, such as bonding sheets or interlayer insulating material sheets, there are cases where distribution in an uncured state before complete curing is desired. In such cases, even if the uncured sheets are rolled for transportation, storage, or other purposes, it is required that the sheets do not stick to each other due to high tackiness (self-adhesiveness) and that their use is not hindered. However, the soft olefin / aromatic vinyl compound / aromatic polyene copolymers specifically described in Patent Literatures 4 to 6 have relatively high tackiness (self-adhesiveness) in the state of uncured sheets or films.

### Solution to Problem

The present invention has been made in view of the above-described problems. An object of the present invention is to provide sheets and the like that have low tackiness in the uncured stage, and whose cured products can exhibit excellent low dielectric characteristics.

That is, the present invention provides various specific aspects as described below.

### Aspect 1.

An uncured sheet composed of a composition containing an olefin / aromatic vinyl compound / aromatic polyene copolymer that satisfies the following condition (2a), and having a tack force at 25°C of 2 N or less by a probe tack test:
(2a) a content of aromatic vinyl compound monomer units is in a range of 60% by mass or more and 80% by mass or less, and a total of aromatic vinyl compound monomer units, aromatic polyene monomer units, and olefin monomer units is 100% by mass.

### Aspect 2.

An uncured sheet composed of a composition containing an olefin / aromatic vinyl compound / aromatic polyene copolymer that satisfies all of the following conditions (1) to (4), and having a tack force at 25°C of 2 N or less as measured by a probe tack test:
(1) a number average molecular weight of the copolymer is 500 or more and 25000 or less;
(2) aromatic vinyl compound monomer units are of an aromatic vinyl compound having 8 or more and 20 or less carbon atoms, and a content of the aromatic vinyl compound monomer units is in a range of 60% by mass or more and 80% by mass or less;
(3) aromatic polyene monomer units are of one or more selected from polyenes having 5 or more and 20 or less carbon atoms and having a plurality of vinyl groups and/or vinylene groups in a molecule, and a content of vinyl groups and/or vinylene groups derived from the aromatic polyene monomer units is 2 or more and less than 30 per number average molecular weight; and
(4) olefin monomer units are of one or more selected from olefins having 2 or more and 20 or less carbon atoms, and a total of the aromatic vinyl compound monomer units, the aromatic polyene monomer units, and the olefin monomer units is 100% by mass.

### Aspect 3.

The uncured sheet according to aspect 1 or 2, wherein the composition further contains one or more selected from the group consisting of the following (a) to (c):
(a) a curing agent;
(b) a radically crosslinkable resin component; and
(c) a radically polymerizable monomer.

### Aspect 4.

The uncured sheet according to aspect 3, wherein the radically crosslinkable resin component (b) is a second olefin / aromatic vinyl compound / aromatic polyene copolymer that is different from the olefin / aromatic vinyl compound / aromatic polyene copolymer and satisfies all of the following conditions (i) to (iv):
(i) a number average molecular weight of the copolymer is 500 or more and less than 100000;
(ii) an aromatic vinyl compound monomer is an aromatic vinyl compound having 8 or more and 20 or less carbon atoms, and a content of aromatic vinyl compound monomer units is 10% by mass or more and less than 55% by mass;
(iii) aromatic polyene monomer units are of one or more selected from polyenes having 5 or more and 20 or less carbon atoms and having a plurality of vinyl groups and/or vinylene groups, preferably vinyl groups, in a molecule, and a content of vinyl groups and/or vinylene groups derived from the aromatic polyene monomer units is 2 or more and less than 20 per number average molecular weight; and
(iv) olefin monomer units are of one or more selected from olefins having 2 or more and 20 or less carbon atoms, a content of the olefin monomer units is 40% by mass or more, and a total of the olefin monomer units, the aromatic vinyl compound monomer units, and the aromatic polyene monomer units is 100% by mass.

### Aspect 5.

The uncured sheet according to any of aspects 1 to 4, which is an interlayer insulating material or a bonding sheet.

### Aspect 6.

A method for producing the uncured sheet according to any of aspects 1 to 5, the method comprising:
a step of kneading raw materials under conditions where curing does not substantially occur to obtain the composition; and
a step of subjecting the composition to forming processing under conditions where curing does not substantially occur to obtain the uncured sheet.

### Aspect 7.

A cured product of the uncured sheet according to any of aspects 1 to 5.

### Aspect 8.

A multilayer substrate comprising the cured product according to aspect 7.

### Advantageous Effect of Invention

According to the present invention, the effect is brought about that it is possible to realize uncured sheets and the like that have low tackiness in the uncured state, are easy to undergo forming processing, are easy to store and handle, and can provide low dielectric insulating materials suitable as high frequency insulating materials by carrying out a curing treatment.

### Description of Embodiments

Hereinafter, embodiments of the present invention will be described in detail. However, the following embodiments are merely examples to describe the present invention, and the present invention is not limited thereto. That is, the present invention can be arbitrarily modified and implemented to the extent that it does not depart from the gist thereof.

In the present specification, the term "sheet" is intended to include the concept of a film as well. Also, even when the term "film" is used in the present specification, it is intended to include the concept of a sheet as well. In the present specification, the term "varnish" includes a composition and at least a solvent. In the present specification, the term "interlayer insulating material" includes the concept of an interlayer adhesive. In the present specification, the term "uncured state" includes the concept of semi-cured, and refers to a state that itself exhibits thermoplasticity (that is, a property that allows forming processing such as sheet formation under forming conditions where curing does not occur), and a state in which curing can be performed by applying appropriate curing conditions (heating, pressurization, and the like) after forming processing.

In the present specification, numerical value ranges are to be construed as including their lower limit values and upper limit values unless otherwise specified. For example, the notation of a numerical value range of "1 to 100" shall encompass both the lower limit value "1" and the upper limit value "100". The same also applies to the notation of other numerical value ranges.

### <Uncured Sheet Containing Olefin / Aromatic Vinyl Compound / Aromatic Polyene Copolymer>

In one embodiment of the present invention, there is provided an uncured sheet composed of a composition containing an olefin / aromatic vinyl compound / aromatic polyene copolymer (hereinafter, sometimes abbreviated as "copolymer") that satisfies the following condition (2a), and having a tack force at 25°C of 2 N or less by a probe tack test.
(2a) The content of aromatic vinyl compound monomer units is in the range of 60% by mass or more and 80% by mass or less, and the total of aromatic vinyl compound monomer units, aromatic polyene monomer units, and olefin monomer units is 100% by mass.

In another embodiment of the present invention, there is provided an uncured sheet composed of a composition (hereinafter, sometimes abbreviated as "resin composition") containing an olefin / aromatic vinyl compound / aromatic polyene copolymer (hereinafter, sometimes abbreviated as "copolymer") that satisfies all of the following conditions (1), (2a), (3), and (4), and having a tack force at 25°C of 2 N or less by a probe tack test.
(1) The number average molecular weight of the copolymer is 500 or more and 25000 or less.
(2a) The content of aromatic vinyl compound monomer units is in the range of 60% by mass or more and 80% by mass or less.
(3) Aromatic polyene monomer units are of one or more selected from polyenes having 5 or more and 20 or less carbon atoms and having a plurality of vinyl groups and/or vinylene groups in the molecule, and the content of vinyl groups and/or vinylene groups derived from the aromatic polyene monomer units is 2 or more and less than 30 per number average molecular weight.
(4) Olefin monomer units are of one or more selected from olefins having 2 or more and 20 or less carbon atoms, and the total of the aromatic vinyl compound monomer units, the aromatic polyene monomer units, and the olefin monomer units is 100% by mass.

In one embodiment, the above (2a) may be the following (2).
(2) Aromatic vinyl compound monomer units are of an aromatic vinyl compound having 8 or more and 20 or less carbon atoms, and the content of the aromatic vinyl compound monomer units is in the range of 60% by mass or more and 80% by mass or less.

In the present specification, the term "uncured state" is defined as a state in which the gel content of the composition forming the sheet (resin component) is 50% by mass or less. The gel content is a value obtained by measurement in accordance with JIS K 6796:1998. The uncured sheet of the present embodiment can be composed of a composition containing an olefin / aromatic vinyl compound / aromatic polyene copolymer and, as necessary, other resin components and additives commonly used in resins, such as a filler, a stabilizer, an antioxidant, and a flame retardant. On the other hand, it is preferable that the composition constituting the uncured sheet of the present embodiment is substantially free from solvents or monomer components that are volatile components, without intentional addition of them. Specifically, "substantially free from volatile components" is defined as a case in which, when a sheet having a thickness of 0.2 mm or less (preferably 0.05 mm or more and 0.2 mm or less) is held for 1 hour at 80°C under a reduced pressure of 10 hectopascals or less, the mass reduction rate (mass change rate) before and after the treatment is less than 1% by mass relative to the mass of the original composition. By being substantially free from volatile components, the present uncured sheet can be stored and distributed in a laminated state or in a wound roll state without causing adhesion (blocking) between sheets at ordinary temperature, while suppressing changes over time in physical properties due to volatilization of the volatile components, which is preferable. In addition, by being substantially free from volatile components, the present uncured sheet has little odor and can suppress deterioration of the working environment, which is preferable. Here, the tack force refers to the tack force at 25°C as measured by a probe tack test. As the probe tack test method, a method is employed in which the load at the time of peeling at a peeling speed of 10 mm/s using a probe tack testing apparatus is measured. More detailed measurement conditions follow the descriptions in the Examples to be described later. From the viewpoint of suppressing the occurrence of blocking between sheets when storing the uncured sheet in a stacked or rolled state, it is necessary that the tack force at 25°C is 2 N or less, preferably 0.5 N or less, more preferably 0.3 N or less, and still more preferably 0.2 N or less. It is inferred that the tack force being in a predetermined range is attributable to the characteristics of the fine phase separation structure in the present sheet.

Here, in the present specification, the term "olefin monomer (unit)" refers to one or more selected from α-olefins having 2 or more and 20 or less carbon atoms and cyclic olefins having 5 or more and 20 or less carbon atoms, which are substantially free from oxygen, nitrogen, or halogen, and are compounds (units) constituted by carbon and hydrogen. Examples of the α-olefins having 2 or more and 20 or less carbon atoms may include, but are not particularly limited to, ethylene, propylene, 1-butene, 1-hexene, 1-octene, 1-decene, 1-dodecene, 4-methyl-1-pentene, and 3,5,5-trimethyl-1-hexene. Examples of the cyclic olefins having 5 or more and 20 or less carbon atoms may include, but are not particularly limited to, norbornene, cyclopentene, dimethanooctahydronaphthalene (DMON), trimethanododecahydroanthracene (TMDA), methylphenylnorbornene (5-methyl-5-phenylbicyclo[2.2.1]hept-2-ene), and acenaphthylene. One that can be preferably used as the olefin is a combination of ethylene and an α-olefin other than ethylene or a cyclic olefin, or ethylene alone.

In the present specification, the term "aromatic vinyl compound monomer (unit)" refers to an aromatic vinyl compound (unit) having 8 or more and 20 or less carbon atoms. Examples of the aromatic vinyl compound monomer may include, but are not particularly limited to, styrene, paramethylstyrene, ethylstyrene (ethylvinylbenzene), paraisobutylstyrene, various vinyl naphthalenes, and various vinylanthracenes.

In the present specification, the term "aromatic polyene monomer (unit)" refers to a polyene compound (unit) having 5 or more and 20 or less carbon atoms and having a plurality of vinyl groups and/or vinylene groups in the molecule. Examples of the aromatic polyene monomer preferably include, but are not particularly limited to, compounds constituted by carbon and hydrogen having an aromatic vinyl structure and being substantially free from oxygen, nitrogen, or halogen, such as various ortho-, meta- and para-divinylbenzenes, and a mixture thereof, divinylnaphthalene, divinylanthracene, p-2-propenylstyrene, and p-3-butenylstyrene. It is also possible to use, as the aromatic polyene monomer, bifunctional aromatic vinyl compounds described in Japanese Patent Laid-Open No. 2004-087639, such as 1,2-bis(vinylphenyl)ethane (abbreviation: BVPE). Among these, various ortho-, meta- and para-divinylbenzenes, or a mixture thereof, are preferably used, and a mixture of meta-divinylbenzene and para-divinylbenzene is more preferably used. In the present specification, these divinylbenzenes are referred to as divinylbenzenes. In the case where divinylbenzenes are used as the aromatic polyene, curing efficiency is high and curing is easy when carrying out a curing treatment, which is preferable.

As for the respective monomers of the above olefin, aromatic vinyl compound, and aromatic polyene, an olefin containing a polar group such as an oxygen atom or a nitrogen atom, an aromatic vinyl compound containing a polar group such as an oxygen atom or a nitrogen atom, or an aromatic polyene containing a polar group such as an oxygen atom or a nitrogen atom may also be included. However, the total mass of these monomers containing a polar group is preferably 10% by mass or less relative to the total mass of the present resin composition, more preferably 3% by mass or less, and most preferably no monomers containing a polar group are contained. By setting the content to 10% by mass or less, there is a tendency that the dielectric characteristics (low dielectric constant/low dielectric loss) of a cured product obtained by curing the present resin composition can be improved.

The number average molecular weight (Mn) of the copolymer can be set as appropriate depending on the desired performance and is not particularly limited, but in one aspect, it may be preferably 500 or more and 25,000 or less, and more preferably 5,000 or more and 25,000 or less. When the number average molecular weight (Mn) is more than 25,000, there may be cases where the embedding property (filling property) into irregularities on the substrate surface is inferior when softening the uncured sheet by heating and allowing it to adhere to the substrate layer, and further, there is a problem that the tack force cannot be sufficiently reduced. When the number average molecular weight (Mn) is less than 500, the mechanical properties of the uncured sheet itself may decrease. In the present specification, the number average molecular weight refers to a value corresponding to the molecular weight in terms of standard polystyrene obtained by the GPC (gel permeation chromatography) method.

Also, the content of the aromatic vinyl compound monomer units contained in the present copolymer is in the range of 60% by mass or more and 80% by mass or less, and preferably 60% by mass or more and 70% by mass or less. By having a content in this range, the tackiness (self-adhesiveness) of the present copolymer and a composition containing the present copolymer in the uncured state is low, and it becomes easy to keep flexibility in the sheet state. From the viewpoint of lowering the tackiness of the uncured sheet while further increasing flexibility, it is also preferable that the content of the aromatic vinyl compound monomer units is in the range of more than 70% by mass and 80% by mass or less. In the case where the content of the aromatic vinyl compound monomer units contained in the present copolymer is less than 60% by mass, the uncured sheet may have high tackiness and self-adhesion (blocking) may easily occur when the sheets are laminated. In the case where the content of the aromatic vinyl compound monomer units contained in the present copolymer is more than 80% by mass, the uncured sheet tends to become hard and easily crack, and for example, the winding property to a roll or the like may decrease. Furthermore, in the case where the content of the aromatic vinyl compound monomer units contained in the present copolymer is in the range of more than 70% by mass and 80% by mass or less, by adding or blending a relatively small amount of a soft component, such as the substances exemplified in the sections below: <Conjugated Diene-Based Polymer, Aromatic Vinyl Compound / Conjugated Diene-Based Block Copolymer or Random Copolymer, and Hydrogenated Product Thereof> and <Another Olefin / Aromatic Vinyl Compound / Aromatic Polyene Copolymer>, it is possible to easily avoid the present uncured sheet from becoming hard.

In the present copolymer, the content of vinyl groups and/or vinylene groups derived from the aromatic polyene monomer units, preferably the content of vinyl groups, may be 2 or more and less than 30 per number average molecular weight, and preferably 3 or more and less than 20. When the content of vinyl groups and/or vinylene groups is less than 2, the crosslinking efficiency is reduced, and it tends to be difficult to obtain a cured product having a sufficient crosslinking density. The content of vinyl groups derived from the aromatic polyene monomer units (divinylbenzene units) per number average molecular weight in the copolymer can be obtained by, for example, comparing the number average molecular weight (Mn) in terms of standard polystyrene determined by the GPC (gel permeation chromatography) method, which is known to those skilled in the art, with the content of vinyl groups derived from the aromatic polyene units obtained by ¹H-NMR measurement. The attribution of peaks obtained in the ¹H-NMR measurement of the copolymer is known in the literature. A method for determining the compositional features of the copolymer from comparison of peak areas obtained in the ¹H-NMR measurement is also known. Furthermore, it is also possible to improve the accuracy of the compositional features by adding data of peak areas and their ratios from the ¹³C-NMR spectrum measured in a known quantitative mode to the method based on the ¹H-NMR measurement. Moreover, it is also possible to determine the compositional features from data of peak areas and their ratios from the ¹³C-NMR spectrum measured in a known quantitative mode. Also, in the present specification, the content of the divinylbenzene units in the copolymer is determined from the peak intensity of vinyl groups derived from the divinylbenzene units (based on the ¹H-NMR measurement). That is, from the content of vinyl groups derived from the divinylbenzene units, regarding one vinyl group as a vinyl group derived from one divinylbenzene unit in the copolymer, the content of the divinylbenzene units is determined.

In one preferable aspect of the present copolymer, the total of the olefin monomer units, the aromatic vinyl compound monomer units, and the aromatic polyene monomer units is 100% by mass. Also, the content of the olefin monomer units is preferably 20% by mass or more and less than 40% by mass.

### <Method for Producing Olefin / Aromatic Vinyl Compound / Aromatic Polyene Copolymer>

The olefin / aromatic vinyl compound / aromatic polyene copolymer of the present embodiment can be produced by copolymerizing the respective monomers of the aromatic vinyl compound, the aromatic polyene, and the olefin to be used as necessary, by coordination polymerization. For example, by using a single-site coordination polymerization catalyst constituted by a transition metal compound and a co-catalyst as described in Japanese Patent Laid-Open No. 2009-161743, Japanese Patent Laid-Open No. 2010-280771, International Publication No. WO 00/37517, and the like, the olefin / aromatic vinyl compound / aromatic polyene copolymer can be produced efficiently, which is preferable.

**In** the present copolymer, examples of the olefin / aromatic vinyl compound / aromatic polyene copolymer (that may contain an olefin) may include, but are not particularly limited to, an ethylene / styrene / divinylbenzene copolymer, an ethylene / propylene / styrene / divinylbenzene copolymer, an ethylene / 1-hexene / styrene / divinylbenzene copolymer, and an ethylene / 1-octene / styrene / divinylbenzene copolymer.

The composition of the present embodiment may be the present copolymer described above alone, but can further contain, as other components, one or more selected from the group consisting of (a) a curing agent, (b) a radically crosslinkable resin component, and (c) a radically crosslinkable monomer.

### <(a) Curing Agent>

As the curing agent that may be contained in the composition of the present embodiment, it is possible to use a known curing agent that can be used for the polymerization or curing of conventional aromatic polyenes or aromatic vinyl compounds. Examples of such a curing agent may include, but are not particularly limited to, radical polymerization initiators (radical generators), cationic polymerization initiators, and anionic polymerization initiators. Preferably, a radical polymerization initiator can be used. Still more preferably, the curing agent is an organic peroxide type (peroxide), an azo type polymerization initiator, or the like, and can be freely selected depending on the application and conditions. A catalog in which organic peroxides are listed is available for download from the website of NOF Corporation, for example, https://www.nof.co.jp/business/functional-materials/functional-materials-product09. In addition, organic peroxides are also described in the catalogs of FUJIFILM Wako Pure Chemical Corporation, Tokyo Chemical Industry Co., Ltd., and the like. The curing agent that can be used in the present embodiment can be obtained from these companies. Furthermore, a hydrocarbon type radical polymerization initiator that is free from oxygen atoms or nitrogen atoms in the structure, that is, composed only of carbon atoms and hydrogen atoms, such as 2,3-dimethyl-2,3-diphenylbutane, can also be suitably used. When a cured product is produced using such a hydrocarbon type radical polymerization initiator, it is possible to obtain a cured product that is free from oxygen atoms or nitrogen atoms and that has a lower dielectric constant and dielectric loss tangent, and the effect is obtained that enables further improvement in low dielectric characteristics of the cured product. In addition, an azo type polymerization initiator is also preferable since the nitrogen atom, which is a polar group contained therein, escapes from the system as nitrogen gas at the time of radical generation and it is thus possible to obtain a cured product that is further excellent in low dielectric property. It is also possible to use a known photopolymerization initiator using light, ultraviolet rays, or radiation as the curing agent. Examples of the photopolymerization initiator include photoradical polymerization initiators, photocationic polymerization initiators, and photoanionic polymerization initiators. Such photopolymerization initiators can be obtained from, for example, Tokyo Chemical Industry Co., Ltd. Furthermore, curing by radiation or electron beams themselves is also possible. It is also possible to carry out crosslinking and curing by thermal polymerization of the contained raw materials with no curing agent contained.

There is no particular restriction on the amount of the curing agent to be used, but in general, 0.01 to 10 parts by mass of the curing agent is preferable relative to 100 parts by mass of the resin composition. In implementation, it is preferable to exclude the curing agent and the solvent from the resin composition. In the case where a curing agent such as an organic peroxide type (peroxide) or azo type polymerization initiator is used, a curing treatment is carried out at an appropriate temperature and time in consideration of its half life. The conditions in this case are arbitrary depending on the curing agent, but in general, a temperature range of about 50°C to 200°C is appropriate.

The composition according to the present embodiment can contain, as the (b) radically crosslinkable resin component, one or more soft resins or hard resins. By adding these components, the mechanical properties of the uncured sheet or the resulting cured product can be adjusted to match the mechanical properties required for various purposes of use. It should be noted that the classification as soft or hard is considered based on the state provided by the manufacturer (state at room temperature and atmospheric pressure).

### <Radically Crosslinkable Soft Resin>

Preferably, examples of the radically crosslinkable soft resin that can be suitably used in the composition of the present embodiment include, but are not particularly limited to, one or more elastomers selected from ethylene-based or propylene-based elastomers having radically crosslinkable functional groups, conjugated diene-based polymers, aromatic vinyl compound / conjugated diene-based block copolymers or random copolymers, and hydrogenated products thereof. The amount of the radically crosslinkable soft resin to be used can be set as appropriate depending on the desired performance from the viewpoints of handleability and forming processability of the composition or the present embodiment in the uncured state (handleability as a thermoplastic resin), as well as reduction of tackiness, and is not particularly limited, but it is preferably 100 parts by mass or less, more preferably in the range of 1 to 50 parts by mass, and most preferably in the range of 1 to 30 parts by mass, relative to 100 parts by mass of the copolymer. The radically crosslinkable soft resin that can be suitably used in the composition of the present embodiment preferably has a number average molecular weight (Mn) of 500 or more and 100,000 or less, and more preferably 1,000 or more and 4,500 or less.

### <Ethylene-Based or Propylene-Based Elastomer Having Radically Crosslinkable Functional Groups>

Examples of the ethylene-based elastomer include, but are not particularly limited to, ethylene / α-olefin copolymers such as an ethylene / octene copolymer and an ethylene / 1-hexene copolymer, EPR, and EPDM, and examples of the propylene-based elastomer include, but are not particularly limited to, atactic polypropylene, polypropylene of low tacticity, and propylene / α-olefin copolymers such as a propylene / 1-butene copolymer. Examples of the radically crosslinkable functional groups include vinyl groups, allyl groups, and ethylidene norbornene groups (units), which are functional groups commonly contained in the rubber raw materials such as EPDM. These radically crosslinkable soft resins may be modified by, for example, introducing functional groups using maleic anhydride or other compounds.

### <Conjugated Diene-Based Polymer, Aromatic Vinyl Compound / Conjugated Diene-Based Block Copolymer or Random Copolymer, and Hydrogenated Product Thereof>

Examples of the conjugated diene-based polymer include, but are not particularly limited to, polybutadiene and 1,2-polybutadiene. Examples of the aromatic vinyl compound / conjugated diene-based block copolymer or random copolymer, and a hydrogenated product thereof include, but are not particularly limited to, SBS, SIS, SEBS, SEPS, SEEPS, and SEEBS. 1,2-Polybutadiene that can be suitably used can be obtained from, for example, Nippon Soda Co., Ltd., under the product names B-1000, 2000, and 3000 as liquid polybutadiene. Also, as a copolymer containing a 1,2-polybutadiene structure that can be suitably used, the product name "Ricon 100" from TOTAL CRAY VALLEY can be exemplified. In addition, the copolymer containing a 1,2-polybutadiene structure, encompassing 1,2-polybutadiene, may be partially hydrogenated for the purpose of improving low dielectric characteristics, for example. These conjugated diene-based polymers and hydrogenated products thereof may be modified by, for example, introducing functional groups using maleic anhydride or other compounds. Among conjugated diene-based polymers, polymers having no vinylene groups in the main chain or fewer vinylene groups are preferable. Vinylene groups in the main chain tend to remain in the cured product even after curing, and these vinylene groups react with oxygen in the air to produce oxygen-containing polar groups, which tends to increase the values of dielectric constant and dielectric loss tangent after a high temperature durability test (for example, 125°C in the air) of the cured product, which is not preferable. From this viewpoint, as the conjugated diene-based polymer, 1,4-polybutadiene-based copolymers are not suitable, and it is preferably a 1,2-polybutadiene-based polymer or copolymer containing a 1,2-polybutadiene structure. Furthermore, from the above viewpoint, various hydrogenated polymers are preferable in which the content of vinylene groups has been significantly reduced due to hydrogenation thereof. Examples of the hydrogenated polymer of the conjugated diene-based polymer include hydrogenated SBR, SEBS, SEPS, SEEPS, and SEEBS, and it is preferably a hydrogenated polymer of the conjugated diene-based polymer having methyl-substituted styrene.

As the radically crosslinkable soft resin that can be suitably used in the composition of the present embodiment, an olefin / aromatic vinyl compound / aromatic polyene copolymer different from the above-described olefin / aromatic vinyl compound / aromatic polyene copolymer (hereinafter sometimes abbreviated as "second copolymer") can also be used.

### <Another Olefin / Aromatic Vinyl Compound / Aromatic Polyene Copolymer (Second Copolymer)>

The composition of the present embodiment can contain one or more selected from second olefin / aromatic vinyl compound / aromatic polyene copolymers, different from the above-described present copolymer, that satisfy all of the following conditions (i) to (iv).
(i) The number average molecular weight of the copolymer is 500 or more and less than 100000.
(ii) Aromatic vinyl compound monomer units are of an aromatic vinyl compound having 8 or more and 20 or less carbon atoms, and the content of the aromatic vinyl compound monomer units is 10% by mass or more and less than 60% by mass, and preferably 10% by mass or more and less than 55% by mass.
(iii) Aromatic polyene monomer units are of one or more selected from polyenes having 5 or more and 20 or less carbon atoms and having a plurality of vinyl groups and/or vinylene groups, preferably vinyl groups, in the molecule, and the content of vinyl groups and/or vinylene groups derived from the aromatic polyene monomer units is 2 or more and less than 20 per number average molecular weight.
(iv) Olefin monomer units are of one or more selected from olefins having 2 or more and 20 or less carbon atoms, the content of the olefin monomer units is 40% by mass or more, and the total of the olefin monomer units, the aromatic vinyl compound monomer units, and the aromatic polyene monomer units is 100% by mass.

Examples of such another second olefin / aromatic vinyl compound / aromatic polyene copolymer satisfying all of the specific conditions include, but are not particularly limited to, those described in International Publication No. WO 2021/112087, International Publication No. WO 2021/112088, International Publication No. WO 2022/014599, and the like. Since such another second olefin / aromatic vinyl compound / aromatic polyene copolymer satisfying all of the specific conditions is soft and exhibits a low dielectric constant and a low dielectric loss tangent, by combining it with the olefin / aromatic vinyl compound / aromatic polyene copolymer of the present embodiment to form a composition, it is possible to give a cured product having a low dielectric constant and a low dielectric loss tangent that covers a wide range of physical properties, which is suitable. Specifically, a composition containing such another second olefin / aromatic vinyl compound / aromatic polyene copolymer in the range of 1 to 50 parts by mass, preferably 1 to 30 parts by mass, relative to 100 parts by mass of the olefin / aromatic vinyl compound / aromatic polyene copolymer of the present embodiment can exhibit the characteristic of low tackiness (self-adhesiveness) in the uncured state.

### <Radically Crosslinkable Hard Resin>

Preferably, examples of the radically crosslinkable hard resin that can be suitably used in the composition of the present embodiment include, but are not particularly limited to, polyether-based resins having radically crosslinkable functional groups, polyether ketone-based resins, and aromatic polyene-based resins. From the viewpoint of not impairing the softness of the present uncured sheet, for example, the amount of the radically crosslinkable hard resin to be used is preferably 1 to 70 parts by mass, more preferably 1 to 50 parts by mass, and still more preferably 1 to 30 parts by mass, relative to 100 parts by mass of the present copolymer. The use of such a hard resin in an amount in the above range is preferable for adjustment of tackiness in an uncured state, adjustment of adhesion of the cured product to other members, and maintenance of strength and a high elastic modulus. The radically crosslinkable hard resin that can be suitably used in the composition of the present embodiment preferably has a number average molecular weight (Mn) of 500 or more and 100,000 or less, and more preferably 1,000 or more and 4,500 or less.

### <Polyether-Based Resin Having Functional Groups>

Examples of the polyether-based resin include, but are not particularly limited to, polyphenylene ether and polyether. As for the polyphenylene ether having functional groups, it is preferable that molecular terminals are modified with functional groups. Furthermore, in the case of addition for the purpose of curing the composition of the present embodiment, it is preferable that a plurality of functional groups are present in one molecule. For example, a modified polyphenylene ether is preferable. Examples of the functional groups include functional groups such as radically polymerizable functional groups and epoxy groups, and radically polymerizable functional groups are preferable. As the radically polymerizable functional groups, vinyl groups are preferable. As the vinyl groups, one or more selected from the group consisting of allyl groups, (meth)acryloyl groups, and aromatic vinyl groups are preferable, one or more selected from the group consisting of (meth)acryloyl groups and aromatic vinyl groups are more preferable, and aromatic vinyl groups are most preferable. That is, in the composition of the present embodiment, a bifunctional polyphenylene ether in which both terminals of the molecular chain have been modified with radically polymerizable functional groups is particularly preferable. Examples of such a polyphenylene ether include, but are not particularly limited to, Noryl (R) SA9000 manufactured by SABIC (modified polyphenylene ether having methacryloyl groups at both terminals, number average molecular weight 2200) and bifunctional polyphenylene ether oligomer manufactured by Mitsubishi Gas Chemical Company (OPE-2St, modified polyphenylene ether having vinylbenzyl groups at both terminals, number average molecular weight 1200). In addition, allylated PPE manufactured by Asahi Kasei Corporation and aromatic polyether manufactured by JSR Corporation (ELPAC HC-F series) can also be used. Among these, preferably, bifunctional polyphenylene ether oligomer manufactured by Mitsubishi Gas Chemical Company (OPE-2St) or aromatic polyether manufactured by JSR Corporation (ELPAC HC-F series) can be used.

### <Aromatic Polyene-Based Resin>

The aromatic polyene-based resin encompasses divinylbenzene-based reactive highly branched copolymers (PDVs or ODVs) manufactured by Nippon Steel Chemical & Material Co., Ltd. Such PDVs are described in, although not particularly limited to, the literature "Syntheses of Multi-Functional Aromatic Copolymers (PDVs) with Controlled Molecular Architectures and Development of Novel Low Dielectric Loss Materials from PDVs" (Masanao Kawabe, Journal of The Japan Institute of Electronics Packaging, p. 125, Vol. 12, No. 2 (2009)), for example.

### <(c) Radically Crosslinkable Monomer>

The radically crosslinkable monomer that may be contained in the present composition is a monomer that can be polymerized by a radical polymerization initiator, and preferably, the content thereof may be preferably 10 parts by mass or less relative to 100 parts by mass of the above copolymer. It should be noted that the present composition may be substantially free from the monomer. When the monomer is 10 parts by mass or less, the uncured composition does not have a viscous property, and forming processing as a thermoplastic resin becomes easy. When the present uncured sheet contains the monomer in the above range, variation in the monomer content during storage is less likely to occur. The monomer that can be suitably used preferably has a molecular weight of less than 1000, and more preferably less than 500. Preferable examples of the monomer include, but are not particularly limited to, aromatic vinyl compound monomers, aromatic polyene monomers, and/or polar monomers. As the monomer, aromatic vinyl compounds and aromatic polyenes are more preferable. In addition, BVPE (1,2-bis(vinylphenyl)ethane) described in Japanese Patent Laid-Open No. 2003-212941 or the like can also be suitably used. From the viewpoint of increasing the mechanical strength (elastic modulus) of the cured product at a high temperature, the aromatic polyene is preferably 1 part by mass or more and 30 parts by mass or less relative to 100 parts by mass of the copolymer. In addition, for the purpose of imparting adhesion to other materials required as insulating materials or improving the crosslinking density, a relatively small amount of a polar monomer can be used. Examples of the above-described polar monomer include, but are not particularly limited to, various maleimides, bismaleimides, maleic anhydride, glycidyl (meth)acrylate, triallyl isocyanurate, tri(meth)acryl isocyanurate, and trimethylolpropane tri(meth)acrylate. The maleimides and bismaleimides that can be used in the present embodiment are described in, for example, International Publication No. WO 2016/114287, Japanese Patent Laid-Open No. 2008-291227, and the like, and can be purchased from Daiwa Kasei Industrial Co., Ltd. or Designer Molecules Inc., for example. Among these maleimide group-containing compounds, bismaleimides are preferable from the viewpoints of solubility in organic solvents, high frequency characteristics, high adhesion to conductors, formability of prepregs, and other factors.

The bismaleimides are preferably bismaleimides represented by the following formula (B-1).

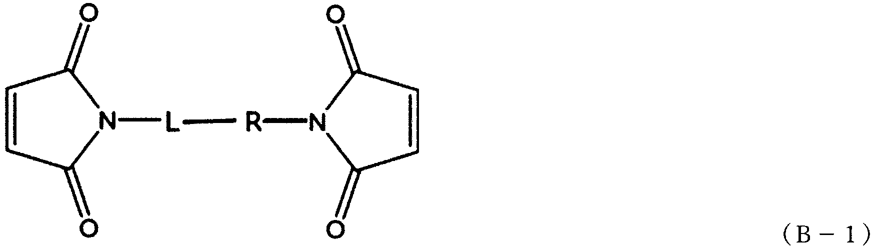

In the formula (B-1), R represents an alkylene group having 5 or more carbon atoms, and L represents a single bond or a divalent linking group. R and L may each independently have a substituent. Also, the maleimides represented by the formula (B-1) are preferably represented by the following formula (B-2).

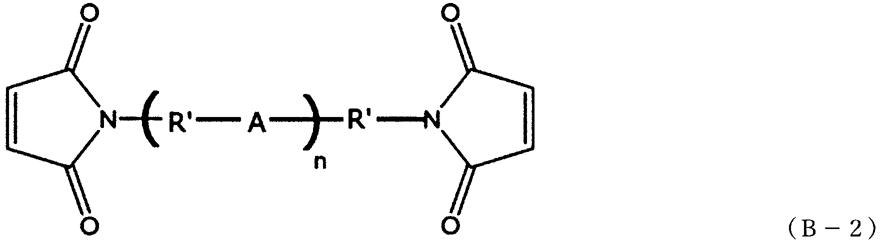

In the formula (B-2), R' each independently represents an alkylene group having 5 or more carbon atoms and optionally having a substituent, and A each independently represents an alkylene group having 5 or more carbon atoms and optionally having a substituent, or a divalent group having an aromatic ring and optionally having a substituent. n represents an integer of 1 to 10.

Examples of the maleimides represented by the formula (B-2) may include compounds represented by the following formula (B-3). In the formula (B-3), n represents an integer of 1 to 10. Examples of the compounds represented by the formula (B-3) include BMI-1500 (n average value = 1.3) manufactured by Designer Molecules Inc.

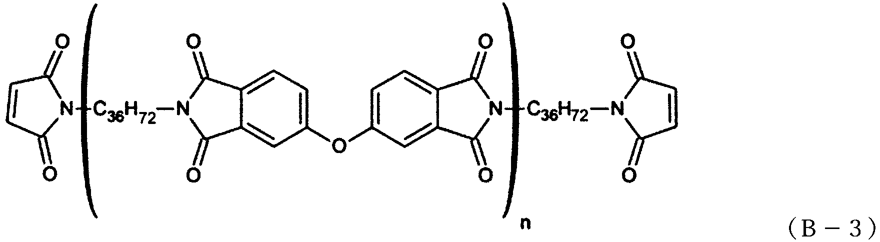

The bismaleimides may be used as polyaminobismaleimide compounds. The polyaminobismaleimide compounds can be obtained by, for example, subjecting a compound having two maleimide groups at the terminals and an aromatic diamine compound having two primary amino groups in the molecule to the Michael addition reaction. In the case where high crosslinking efficiency is desired with a small amount of addition, it is preferable to use a polar monomer having bifunctional or multifunctional groups, and examples of such a polar monomer may include bismaleimides, triallyl isocyanurate (TAIC), and trimethylolpropane tri(meth)acrylate. The amount of the polar monomer that may be contained in the composition can be set as appropriate depending on the desired performance and is not particularly limited, but it is preferably in the range of 0.1 to 10 parts by mass, and more preferably 0.1 to 5 parts by mass, relative to 100 parts by mass of the copolymer. By using 10 parts by mass or less, the resulting cured product tends to have a low dielectric constant and a low dielectric loss tangent. For example, the dielectric constant tends to be below 3.0, and the dielectric loss tangent tends to be below 0.005.

Furthermore, the composition of the present embodiment may contain one or more selected from the following (d) to (f), as long as the low tackiness of the uncured sheet and the dielectric characteristics of the cured product thereof are not excessively impaired:
(d) a filler;
(e) a flame retardant; and
(f) a surface modifying agent.

In one preferable embodiment, from the viewpoint of achieving both low tackiness and low dielectric characteristics, it is desirable that these additives are added in a small amount (for example, each in an amount of 100 parts by mass or less relative to 100 parts by mass of the above copolymer) or are substantially not contained.

### <Filler>

A known inorganic or organic filler may be added as necessary. In one aspect, these fillers are added for the purposes of controlling the coefficient of thermal expansion, controlling thermal conductivity, or reducing cost. The amount used is arbitrary depending on the purpose. In particular, when adding an inorganic filler, it is preferable to use a known surface modifying agent such as a silane coupling agent. Especially, in the case of aiming at a resin composition excellent in low dielectric constant and low dielectric loss, which is one of the objects of the present embodiment, one or more composed of boron nitride (BN) or silica is preferable as the inorganic filler, and silica is more preferable. As the silica, fused silica is preferable. From the viewpoint of low dielectric characteristics, preferably, 100 parts by mass or less of the filler may be used relative to 100 parts by mass of the copolymer. Furthermore, in order to improve or enhance low dielectric characteristics (low dielectric constant and low dielectric loss tangent), a hollow filler or a filler having a shape with many voids may be added.

It is also possible to use an organic filler such as high molecular weight polyethylene or ultrahigh molecular weight polyethylene instead of the inorganic filler. From the viewpoint of heat resistance, it is preferable that the organic filler itself is crosslinked, and it is preferable that it is blended in the state of fine particles or powder. By blending these organic fillers, there is a tendency that the increase in dielectric constant and dielectric loss tangent can be suppressed.

On the other hand, by mixing and dispersing, in the resin composition of the present embodiment, a high dielectric constant insulating filler having a dielectric constant at 1 GHz of preferably 4 to 10,000, more preferably 5 to 10,000, it is also possible to produce an insulating cured product having a high dielectric constant insulating layer with a dielectric constant of preferably 4 to 20, while suppressing an increase in dielectric loss tangent (dielectric loss). By increasing the dielectric constant of a film composed of the insulating cured product, it becomes possible to miniaturize circuits and increase the capacitance of capacitors, thereby contributing to miniaturization of high frequency electrical components, for example. A high dielectric constant and low dielectric loss tangent insulating layer is suited for applications such as capacitors, resonant circuit inductors, filters, and antennas. Examples of the high dielectric constant insulating filler used in the present embodiment include, but are not particularly limited to, inorganic fillers or metal particles subjected to an insulation treatment. Specific examples thereof include known high dielectric constant inorganic fillers such as barium titanate and strontium titanate, and for example, they are specifically described in Japanese Patent Laid-Open No. 2004-087639.

### <Flame Retardant>

A flame retardant can be used in the composition of the present embodiment. From the viewpoint of retaining a low dielectric constant and a low dielectric loss tangent, preferable examples of the flame retardant include known organic phosphorus-based flame retardants such as phosphate esters or condensates thereof, known bromine-based flame retardants, and red phosphorus. Among the phosphate esters, compounds having a plurality of xylenyl groups in the molecule are particularly preferable from the viewpoints of flame retardancy and low dielectric loss tangent.

Furthermore, in addition to the flame retardant, an antimony-based compound such as antimony trioxide, antimony tetroxide, antimony pentoxide, or sodium antimonate, or a nitrogen-containing compound such as melamine, triallyl-1,3,5-triazine-2,3,4-(1H,3H,5H)-trione, or 2,4,6-triallyloxy-1,3,5-triazine may be added as a flame retardant auxiliary. The total of the flame retardant and the flame retardant auxiliary can be set as appropriate depending on the desired performance and is not particularly limited, but preferably, it is usually 1 to 100 parts by mass relative to 100 parts by mass of the above copolymer. In addition, a polyphenylene ether (PPE)-based resin excellent in low dielectric constant and flame retardancy may be used in an amount of 30 to 100 parts by mass relative to 100 parts by mass of the flame retardant.

### <Surface Modifying Agent>

The composition of the present embodiment may contain a surface modifying agent from the viewpoint of improving adhesion to copper foil for wiring, for example. In particular, it may be for the purpose of enhancing the adhesion strength (peel strength) to the smooth surface of copper foil. The amount of the surface modifying agent to be used can be set as appropriate depending on the desired performance and is not particularly limited, but it is preferably in the range of 0.001 to 10 parts by mass, more preferably in the range of 0.01 to 5 parts by mass, and most preferably in the range of 0.01 to 1 part by mass, relative to 100 parts by mass of the olefin / aromatic vinyl compound / aromatic polyene copolymer. By setting the amount of the surface modifying agent to be used to 10 parts by mass or less, the dielectric constant and dielectric loss tangent of the cured product obtained from the present composition tend to be low. Also, in the present embodiment, a known surface modifying agent can be used. Examples of such a surface modifying agent include, but are not particularly limited to, silane-based surface modifying agents (also called silane coupling agents), titanate-based surface modifying agents, and isocyanate-based surface modifying agents. Preferably, silane-based surface modifying agents can be used. These surface modifying agents may be used singly or in combination. Such silane-based surface modifying agents can be obtained from, for example, Shin-Etsu Chemical Co., Ltd., Dow Corning Toray Co., Ltd., or Evonik Industries AG.

The composition or varnish of the present embodiment can contain, to the extent that the desired effects or purposes are not inhibited, additives commonly used in resins in the art, such as an antioxidant, a weathering agent, a light stabilizer, a lubricant, a compatibilizer, and an antistatic agent. The composition or varnish of the present embodiment can be obtained by mixing, dissolving, or melting these various additives, and any known method can be employed for mixing, dissolving, or melting.

### <Resin Composition>

The resin composition or the like of the present embodiment can be mixed by a known kneading method, for example, using twin-screw kneaders, various rolls, or various kneaders.

### <Varnish>

An uncured sheet according to the present embodiment can be produced from a varnish. The varnish can be obtained by dissolving or dispersing the copolymer and other raw materials described above in a solvent. As the solvent, one having a boiling point at a certain level or higher is preferable since when the boiling point at atmospheric pressure is high, that is, when the volatility is low, the thickness of the applied film is uniform. The boiling point is preferably about 75°C or higher at atmospheric pressure, and still more preferably 130°C or higher and 300°C or lower. As the solvent, those known in the art can be used without particular limitation, and for example, cyclohexane, cyclohexanone, methyl ethyl ketone (MEK), toluene, ethylbenzene, xylene, mesitylene, tetralin, acetone, limonene, mixed alkanes, mixed aromatic solvents, and the like are used. The concentration of the resin component in the varnish and the viscosity of the varnish may be arbitrary, but in general, the viscosity is several hundred thousand mPa·s or less at room temperature, suitably several tens of thousands mPa·s or less, more suitably 10,000 mPa·s or less, and most preferably 2000 mPa·s or less. The amount of the solvent to be used can be set as appropriate depending on the desired performance and is not particularly limited, but it is preferably 10 to 2000 parts by mass relative to 100 parts by mass of the composition of the present embodiment. Specifically, the varnish can be applied, impregnated, filled, or dropped onto other materials by appropriate methods and the solvent can be removed, thereby obtaining a formed product. Furthermore, the formed product can be cured by heat or light, thereby obtaining the desired cured product. Also, the polymerization solution obtained when copolymerizing the olefin / aromatic vinyl compound / aromatic polyene copolymer of the present embodiment (generally containing, in addition to the present copolymer, the solvent used in polymerization such as toluene, ethylbenzene, cyclohexane, or methylcyclohexane, residual monomers such as styrene or divinylbenzene and residual monomers such as olefin monomers, catalyst, and co-catalyst component) can be used as the varnish as it is. Alternatively, part or all of the solvent and residual monomers in this polymerization solution can be distilled off under reduced pressure, which is diluted with the solvent as necessary, thereby obtaining the varnish. That is, the varnish may contain the residual monomers during polymerization and the solvent used in polymerization. By substantially removing the solvent from this varnish, an uncured sheet according to the present embodiment can be obtained.

### <Sheet in Uncured State>

The shape and thickness of a sheet in an uncured state obtained from the composition of the present embodiment are arbitrary. The sheet may be a single layer, or may be one or more layers included in a multilayer sheet. In the case of a multilayer sheet, it may further include a base layer or a protective layer. Since the uncured sheet of the present embodiment has low tackiness, peeling from a protective layer or base layer sheet can be easily carried out in practical use. In the case of a resinous composition, since the uncured sheet of the present embodiment exhibits the properties of a thermoplastic resin, it can be formed into the shape of a sheet in a substantially uncured state by known forming processing methods for thermoplastic resins, such as extrusion molding, press molding, or inflation molding, under conditions where substantial crosslinking does not occur. For example, in the case of a varnish-like composition, after applying it onto a base, removal of the solvent by heating, reduced pressure, air drying, or the like generally results in a sheet-shaped formed product. By these methods, the uncured sheet can be obtained. In addition, a sheet-shaped composite can also be obtained by impregnating a porous base, woven fabric, or non-woven fabric with the varnish of the present embodiment and removing the solvent.

In the case of an interlayer insulating material (bonding sheet), which is an application of the present composition, it is in the form of a sheet or a film. In such applications, it may be necessary to laminate it in an uncured state with a protective film as needed or to roll it up for storage and transportation, and in such cases, low tackiness (self-adhesiveness) is required. If the tackiness is high, it becomes difficult to separate it as an interlayer insulating material sheet at the time of actual use due to self-adhesion. The tackiness can be reduced by adding a filler or a sub-raw material (preferably hard). In some cases, it is important to reduce the tackiness of the olefin / aromatic vinyl compound / aromatic polyene copolymer itself, which is the main component, in order to reduce the tackiness of the present sheet. Specifically, it is preferable that the tackiness of the uncured sheet of the present olefin / aromatic vinyl compound / aromatic polyene copolymer itself, which is the main constituent component, has a tack force of 2 N or less by a probe tack measurement. The sheet or film may be uncured (semi-cured) to the extent that the shape can be maintained, or may have been fully cured. The degree of curing of the composition can be quantitatively measured by gel content measurement, flowability measurement, or known dynamic viscoelastic measurement methods (DMA, dynamic mechanical analysis). The present formed product in an uncured state can be crosslinked (cured) later.

### <Curing>

Curing of the uncured sheet of the present embodiment can be carried out by a known method, taking into consideration the curing conditions (temperature, time, pressure) of the contained raw materials and curing agent. When the curing agent used is a peroxide, the curing conditions can be determined with reference to the half life temperature or the like disclosed for each peroxide.

### <Cured Product Obtained from Composition, and Cured Product of Formed Product>

The cured product of the sheet obtained from the composition of the present embodiment has been sufficiently cured, and the gel content (gel fraction) measured in accordance with the description of JIS K 6796:1998 is not particularly limited, but may be 90% by mass or more. Moreover, in the measurement range of 10 to 50 GHz, particularly preferably at 10 GHz, the dielectric constant of the cured product is not particularly limited, but is preferably 3.0 or less and 2.0 or more, more preferably 2.8 or less and 2.0 or more, and most preferably 2.5 or less and 2.0 or more. Similarly, the dielectric loss tangent is not particularly limited, but is preferably 0.0015 or less and 0.0005 or more, and more preferably 0.0012 or less and 0.0005 or more. In addition, the volume resistivity of the obtained cured product is not particularly limited, but is preferably 1 × 10¹⁵ Ω·cm or more. Furthermore, the water absorption is not particularly limited, but is preferably 0.1% by mass or less, and such a cured product is preferable as an electrical insulating material. These values are particularly preferable values for high frequency electrical insulating materials of 3 GHz or more, for example.

The cured product obtained from the uncured sheet of the present embodiment is particularly suitable as an electrical insulating material for high frequency signals, and such a cured product can be suitably used for CCL substrates, FCCL substrates, interlayer insulating materials, or coverlays. Also, in one present embodiment, it is a CCL substrate, a FCCL substrate, an interlayer insulating material, or a coverlay composed of the present copolymer or a composition containing the same. The present embodiment can be suitably used for multilayer substrates.

### Examples

The characteristics of the present invention will be further specifically described by means of Examples and Comparative Example below, but the present invention is not limited in any way by them. That is, the materials, amounts used, proportions, treatment contents, treatment procedures, and other factors shown in Examples below can be changed as appropriate, as long as they do not depart from the spirit of the present invention. Also, the values of various production conditions and evaluation results in Examples below have meanings as preferable upper limit values or preferable lower limit values in the implementation of the present invention, and preferable numerical value ranges may be ranges defined by the combination of the upper limit values or lower limit values described above and the values in Examples below or the values among Examples.

The analysis of the copolymers obtained in the Synthesis Examples and the analysis of the compositions were performed by the following means.

### <Analysis of Chemical Structure of Compound>

The determination of the content of vinyl group units derived from ethylene, styrene, and divinylbenzene in the copolymer was carried out by ¹H-NMR, based on the peak area intensity attributed to each. The sample was dissolved in deuterated 1,1,2,2-tetrachloroethane, and the measurement was carried out at 80 to 130°C.

### <Measurement of Molecular Weight>

The molecular weight was determined as the number average molecular weight (Mn) in terms of standard polystyrene using GPC (gel permeation chromatography). The measurement was carried out under the following conditions.
Column: Four TSKgel Multipore HXL-M columns of φ7.8 × 300 mm (manufactured by Tosoh Corporation) connected in series were used.
Column temperature: 40°C
Solvent: THF
Flow rate: 1.0 ml/min.
Detector: RI detector

### <Gel Content>

**The gel content** as the boiling xylene-insoluble matter was determined in accordance with JIS K 6796:1998.

### <Dielectric Constant and Dielectric Loss (Dielectric Loss Tangent)>

The dielectric constant and the dielectric loss tangent were measured by the split-cylinder resonator method. Using, as the measuring apparatus, the 8722ES Network Analyzer manufactured by Agilent Technologies and a split-cylinder resonator (CR-740, 40 GHz) manufactured by EM labs Inc., a sample of 0.2 mm × 30 mm × 40 mm was cut from the sheet, and measurements were performed at 23°C over a frequency range of 35 to 42 GHz.

### <Tensile Elastic Modulus>

In accordance with JIS K 6251:2017, the cured product of the composition according to each Example and Comparative Example was formed into a film sheet with a thickness of about 1 mm, cut into the shape of No. 2 dumbbell No. 1/2 type test piece, and measurement was performed using Tensilon UCT-1T manufactured by Orientec Corporation at 25°C with a tensile speed of 500 mm/min, thereby determining the tensile elastic modulus.

### <Evaluation of Tackiness>

The varnish-like compositions fabricated in Examples and Comparative Example were each applied with an applicator onto a Teflon (R) sheet so that the film thickness after drying was about 50 µm, and sufficiently dried in a vacuum dryer at 80°C and a vacuum degree of 10 hectopascals or less for 3 hours or longer until it was confirmed that the mass change rate per 1 hour of drying was less than 1% by mass. The apparatus used was a probe tack tester (TE6001, manufactured by Tester Sangyo Co., Ltd.) with a φ5.05 mm stainless steel probe. At 25°C, under a load of 1 kgf/cm², the probe was pressed onto the sample surface at a contact speed of 10 mm/s and held for 10 seconds. Afterward, the probe was detached at a separation speed of 10 mm/s, and the load at that time was measured. This measurement was carried out eight times, and the average value of the measured values was taken as the tack force.

### <Production of Copolymer>

Referring to the production methods described in Japanese Patent Laid-Open No. 2009-161743, Japanese Patent Laid-Open No. 2010-280771, and International Publication No. WO 2017/122295, the production of each compound was carried out. As catalysts, Rac-diphenylmethylene(1-indenyl)(cyclopentadienyl)zirconium dichloride (as for the structure, see formula (1) below), Rac-dimethylmethylenebis(4,5-benzo-1-indenyl)zirconium dichloride (as for the structure, see formula (2) below), and dimethylmethylenebis(cyclopentadienyl)zirconium dichloride (as for the structure, see formula (3) below) were used; as a co-catalyst, trityl tetrakis(pentafluorophenyl)borate (TRI-FABA, manufactured by Tosoh Finechem Corp.) was used; as a solvent, toluene was used; and as raw materials, styrene, divinylbenzene, ethylene, and optionally 1-octene were used. Using a 10 L polymerization can which is equipped with a stirrer and a jacket for heating and cooling, polymerization was carried out adjusting the monomer concentration, ethylene pressure, and polymerization temperature as appropriate in order to obtain a copolymer having the desired compositional features and molecular weight.

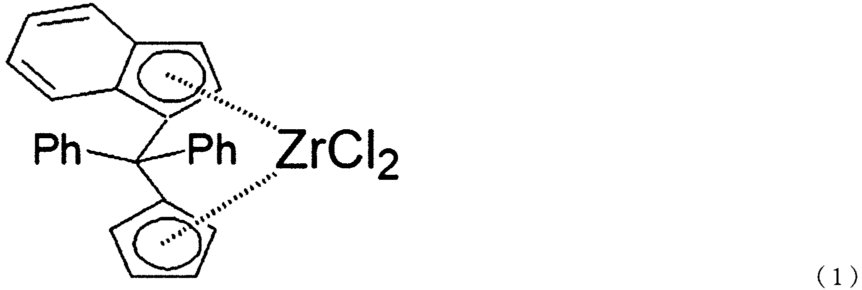

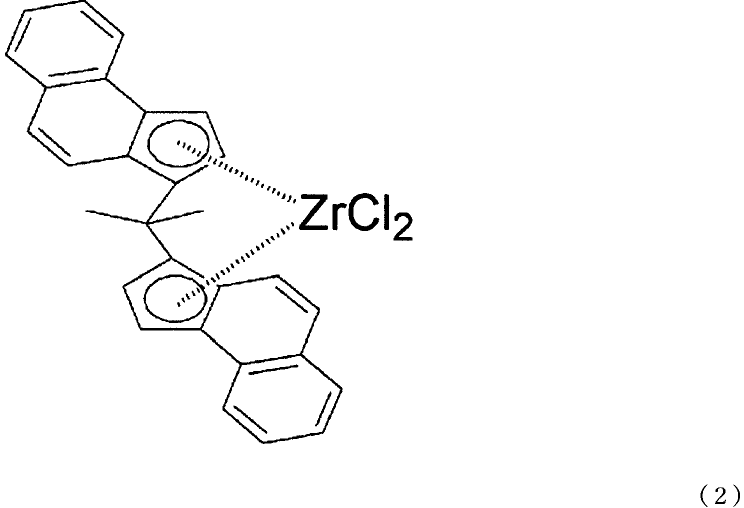

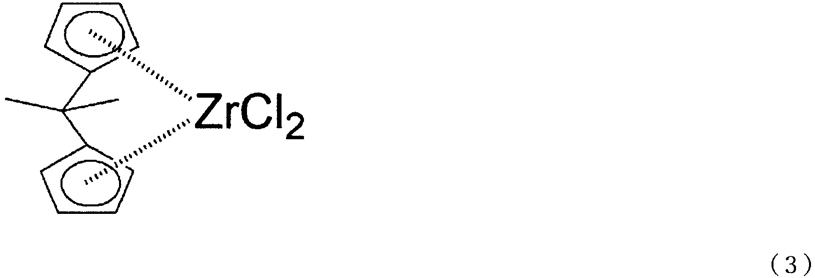

### (Synthesis Example P-1)

Using Rac-diphenylmethylene(1-indenyl)(cyclopentadienyl)zirconium dichloride as the catalyst and trityl tetrakis(pentafluorophenyl)borate as the co-catalyst, copolymerization of ethylene, styrene, and divinylbenzene was carried out to obtain a copolymer P-1. Table 1 shows the compositional features and number average molecular weight of the copolymer.

### (Synthesis Example P-2)

Using Rac-dimethylmethylenebis(4,5-benzo-1-indenyl)zirconium dichloride as the catalyst and trityl tetrakis(pentafluorophenyl)borate as the co-catalyst, copolymerization of ethylene, styrene, 1-octene, and divinylbenzene was carried out to obtain P-2. Table 1 shows the compositional features and number average molecular weight of the copolymer.

### (Synthesis Example P-3)

Using dimethylmethylenebis(cyclopentadienyl)zirconium dichloride and trityl tetrakis(pentafluorophenyl)borate as the co-catalyst, copolymerization of ethylene, styrene, and divinylbenzene was carried out to obtain P-3. Table 1 shows the compositional features and number average molecular weight of the copolymer.

### (Synthesis Example P-4)

Using Rac-diphenylmethylene(1-indenyl)(cyclopentadienyl)zirconium dichloride as the catalyst and trityl tetrakis(pentafluorophenyl)borate as the co-catalyst, copolymerization of ethylene, styrene, and divinylbenzene was carried out to obtain P-4. Table 1 shows the compositional features and number average molecular weight of the copolymer.

Other raw materials were as follows.

As for bifunctional polyphenylene ether oligomer (OPE-2St, modified polyphenylene ether having vinylbenzyl groups at both terminals, number average molecular weight 1200), a toluene solution product manufactured by Mitsubishi Gas Chemical Company was further diluted with toluene, followed by methanol precipitation by adding a large amount of methanol, and after air drying and subsequent vacuum drying, a powdered polyphenylene ether oligomer was obtained and used.

SEBS: Hydrogenated styrene-based thermoplastic elastomer (SEBS), "Tuftec H1041" manufactured by Asahi Kasei Corporation, number average molecular weight 58,000

The curing agent used was PERBUTYL P (α,α'-di(t-butylperoxy)diisopropylbenzene) manufactured by NOF Corporation.

**[Table 1]**

| | Ethylene content | 1-Octene content | Styrene content | Divinylbenzene vinyl groups | Number average molecular weight |
|---|---|---|---|---|---|
| Copolymerized oligomer, or polymer | % by mass | % by mass | % by mass | (number per number average molecular weight) | Mn |
| P-1 | 34 | 0 | 61 | 8.0 | 20800 |
| P-2 | 22 | 7 | 66 | 6.0 | 17200 |
| P-3 | 48 | 0 | 45 | 3.6 | 7000 |
| P-4 | 43 | 0 | 54 | 5.8 | 22000 |

**[Table 2]**

| | Example 1 | Example 2 | Example 3 | Example 4 | Comparative Example 1 | Comparative Example 2 | Comparative Example 3 |
|---|---|---|---|---|---|---|---|
| P-1 | 100 | - | 100 | - | - | - | - |
| P-2 | - | 100 | - | 100 | - | - | - |
| P-3 | - | - | - | - | 100 | - | 100 |
| P-4 | - | - | - | - | - | 100 | - |
| SEBS | - | - | - | 20 | - | - | - |
| OPE-2St | - | - | 30 | - | - | - | 30 |
| Solvent (toluene) | 200 | 200 | 200 | 200 | 200 | 200 | 200 |
| Curing agent PERBUTYL P* | 1 | 1 | 1 | 1 | 1 | 1 | 1 |
| Gel content of uncured sheet / % by mass | <5 | <5 | <5 | <5 | <5 | <5 | <5 |
| Tack force of uncured sheet / N | 0.18 | 0.1 | 0.05 | 0.15 | 7.8 | 5.0 | 2.9 |
| Gel content of cured sheet / % by mass | >90 | >90 | >90 | >90 | >90 | >90 | >90 |
| Tensile elastic modulus (25°C) / MPa | 28 | 25 | 140 | 26 | 5 | 7 | 70 |
| Dielectric constant (10 GHz) | 2.4 | 2.4 | 2.5 | 2.4 | 2.4 | 2.3 | 2.5 |
| Dielectric loss tangent (10 GHz) | 0.0007 | 0.0008 | 0.0012 | 0.0008 | 0.0007 | 0.0007 | 0.0013 |

| | | | | | | | |
|---|---|---|---|---|---|---|---|
| *The curing agent was added in an amount of 1 part by mass relative to 100 parts by mass of the raw materials other than the solvent and the curing agent. | | | | | | | |

### (Example 1)

Using a container which is equipped with a jacket for heating and cooling and a stirring blade, P-1 (ethylene / styrene / divinylbenzene copolymer) obtained in Synthesis Example and the solvent (toluene) were mixed according to the formulation in Table 2 (units in the table are parts by mass), heated to about 60°C, and stirred to dissolve the copolymer. Furthermore, 1 part by mass of the curing agent was added relative to 100 parts by mass of the resin component excluding the curing agent and solvent, dissolved, and mixed by stirring to obtain a varnish-like composition. The obtained composition was poured into a Teflon (R) mold (frame length 7 cm, width 7 cm, thickness 0.2 mm, 0.5 mm, or 1.0 mm) on a PET sheet placed on a glass plate, air-dried, and then further dried in a vacuum dryer at 80°C and a pressure of 10 hectopascals or less for 3 hours or longer to obtain an uncured sheet. Here, the sheet was taken out while drying in the vacuum dryer, and the sheet mass was measured to confirm that the mass change rate per 1 hour of drying was less than 1% by mass. The same confirmation was performed in the following Examples. Furthermore, under a load of 5 MPa with a press machine, a Teflon sheet and a Teflon mold were placed, a heating treatment was performed at 120°C for 30 minutes, 150°C for 30 minutes, and then 200°C for 120 minutes, after which the Teflon sheet and the Teflon mold were removed to obtain a cured sheet.

### (Examples 2 to 4)

Following the same procedures as in Example 1, curable resin compositions were prepared according to the formulations in Table 2 (units in the table are parts by mass), and by the same procedures, uncured sheets and cured sheets of the compositions of Examples were obtained.

### (Comparative Examples 1 to 3)

Following the same procedures as in Example 1, curable resin compositions were prepared according to the formulations in Table 2 (units in the table are parts by mass), and by the same procedures, uncured sheets and cured sheets of the compositions of Comparative Examples were obtained.

The tackiness of the uncured sheet obtained in each Example and Comparative Example was evaluated. The tack force (adhesive force) of the uncured sheet obtained in each Example was very small, satisfying the condition that the tack force at 25°C by the probe tack test was 2 N or less. In contrast, the tack force (adhesive force) of the uncured sheets obtained in Comparative Examples was all large and did not satisfy the condition that the tack force at 25°C by the probe tack test was 2 N or less.

The tensile elastic modulus, dielectric constant, and dielectric loss tangent at 25°C of the cured sheet obtained in each Example and Comparative Example are shown in Table 2. It can be seen that the cured sheets according to Examples all exhibit a low dielectric constant and dielectric loss tangent, comparable to those of Comparative Examples.

## Claims

1. An uncured sheet composed of a composition comprising an olefin / aromatic vinyl compound / aromatic polyene copolymer that satisfies the following condition (2a), and having a tack force at 25°C of 2 N or less by a probe tack test: (2a) a content of aromatic vinyl compound monomer units is in a range of 60% by mass or more and 80% by mass or less, and a total of aromatic vinyl compound monomer units, aromatic polyene monomer units, and olefin monomer units is 100% by mass.

2. An uncured sheet composed of a composition comprising an olefin / aromatic vinyl compound / aromatic polyene copolymer that satisfies all of the following conditions (1) to (4), and having a tack force at 25°C of 2 N or less as measured by a probe tack test:
(1) a number average molecular weight of the copolymer is 500 or more and 25000 or less;
(2) aromatic vinyl compound monomer units are of an aromatic vinyl compound having 8 or more and 20 or less carbon atoms, and a content of the aromatic vinyl compound monomer units is in a range of 60% by mass or more and 80% by mass or less;
(3) aromatic polyene monomer units are of one or more selected from polyenes having 5 or more and 20 or less carbon atoms and having a plurality of vinyl groups and/or vinylene groups in a molecule, and a content of vinyl groups and/or vinylene groups derived from the aromatic polyene monomer units is 2 or more and less than 30 per number average molecular weight; and
(4) olefin monomer units are of one or more selected from olefins having 2 or more and 20 or less carbon atoms, and a total of the aromatic vinyl compound monomer units, the aromatic polyene monomer units, and the olefin monomer units is 100% by mass.

3. The uncured sheet according to claim 1 or 2, wherein the composition further comprises one or more selected from the group consisting of the following (a) to (c):
(a) a curing agent;
(b) a radically crosslinkable resin component; and
(c) a radically polymerizable monomer.

4. The uncured sheet according to claim 3, wherein the radically crosslinkable resin component (b) is a second olefin / aromatic vinyl compound / aromatic polyene copolymer that is different from the olefin / aromatic vinyl compound / aromatic polyene copolymer and satisfies all of the following conditions (i) to (iv):
(i) a number average molecular weight of the copolymer is 500 or more and less than 100000;
(ii) an aromatic vinyl compound monomer is an aromatic vinyl compound having 8 or more and 20 or less carbon atoms, and a content of aromatic vinyl compound monomer units is 10% by mass or more and less than 55% by mass;
(iii) aromatic polyene monomer units are of one or more selected from polyenes having 5 or more and 20 or less carbon atoms and having a plurality of vinyl groups and/or vinylene groups, preferably vinyl groups, in a molecule, and a content of vinyl groups and/or vinylene groups derived from the aromatic polyene monomer units is 2 or more and less than 20 per number average molecular weight; and
(iv) olefin monomer units are of one or more selected from olefins having 2 or more and 20 or less carbon atoms, a content of the olefin monomer units is 40% by mass or more, and a total of the olefin monomer units, the aromatic vinyl compound monomer units, and the aromatic polyene monomer units is 100% by mass.

5. The uncured sheet according to claim 1 or 2, which is an interlayer insulating material or a bonding sheet.

6. A method for producing the uncured sheet according to claim 1 or 2, the method comprising:
a step of kneading raw materials under conditions where curing does not substantially occur to obtain the composition; and
a step of subjecting the composition to forming processing under conditions where curing does not substantially occur to obtain the uncured sheet.

7. A cured product of the uncured sheet according to claim 1 or 2.

8. A multilayer substrate comprising the cured product according to claim 7.
